Europäisches Patentamt

European Patent Office

Office européen des brevets

(11) Publication number: **0 088 216**
A2

# EUROPEAN PATENT APPLICATION

(21) Application number: **83100687.9**

(22) Date of filing: **26.01.83**

(51) Int. Cl.³: **H 01 L 31/10, H 01 L 31/02**

(30) Priority: **05.03.82 US 354990**

(43) Date of publication of application: **14.09.83 Bulletin 83/37**

(84) Designated Contracting States: **DE FR GB**

(71) Applicant: **International Business Machines Corporation, Old Orchard Road, Armonk, N.Y. 10504 (US)**

(72) Inventor: **Fang, Frank Fu, 1691 Cardinal Court, Yorktown Heights New York, 10598 (US)**
Inventor: **Seitz, Hugo Carl, Wilenstrasse 187, CH-8832 Wollerau (CH)**

(74) Representative: **Hobbs, Francis John, IBM United Kingdom Patent Operations Hursley Park, Winchester Hants, SO21 2JN (GB)**

(54) **Radiation detector and method of fabricating a radiation detector.**

(57) A high speed PIN photodetector having high efficiency in the 900nm wavelength region consists of a parallel-sided web (2¹) of silicon disposed obliquely between a parallel pair of strips (7) of silicon dioxide, opposite surface layers (3, 4) of the web being of different conductivity types and supporting contiguous radiation reflecting electrodes (5, 6). Radiation may be detected through one or both of the strips (3, 4) of silicon dioxide or alternatively the radiation may be coupled to an end of the web via an optical fibre (23).

The web of silicon may be formed by anisotropically etching V-grooves in both sides of a silicon substrate.

RADIATION DETECTOR AND METHOD OF FABRICATING A
RADIATION DETECTOR

This invention relates to radiation detectors and methods of fabricating radiation detectors. A preferred application of the invention is a PIN semiconductor photodetector which has high speed and high efficiency in the 900nm wavelength region.

U.S. Patent 4,294,510 discloses a trapezoidally shaped photodetector wherein the optical path length is longer than the device length.

The invention seeks to provide an improved radiation detector which absorbs substantially all of the incident radiation and has a short transit time.

A radiation detector comprising a parallel pair of strips of insulating material joined by a body of semiconductor material, one surface layer of the body being of one conductivity type and an opposite surface layer of the body being of the opposite conductivity type is characterised, according to the invention, by the body being in the form of a parallel-sided web disposed obliquely to the parallel pair of strips, one surface layer of the web being of p-type conductivity type and the opposite surface layer of the web being of n-type conductivity.

A method of fabricating a radiation detector as defined in the preceding paragraph, comprises the step of anistropically etching a semiconductor substrate from opposite sides thereof to provide a web of semiconductor material the opposing surfaces of which are parallel.

The invention will now be described by way of example, with reference to the accompanying drawings, in which:-

FIG. 1 represents a perspective view of a semiconductor PIN photodetector;

FIGS. 2.1-2.7 represents intermediate stages in a fabrication process for the photodetector;

FIG. 2.8 represents a stage in a fabrication process for a photodetector to which light is coupled by an optical fibre; and

FIG. 3 represents a PIN photodector to which light is coupled by an optical fibre.

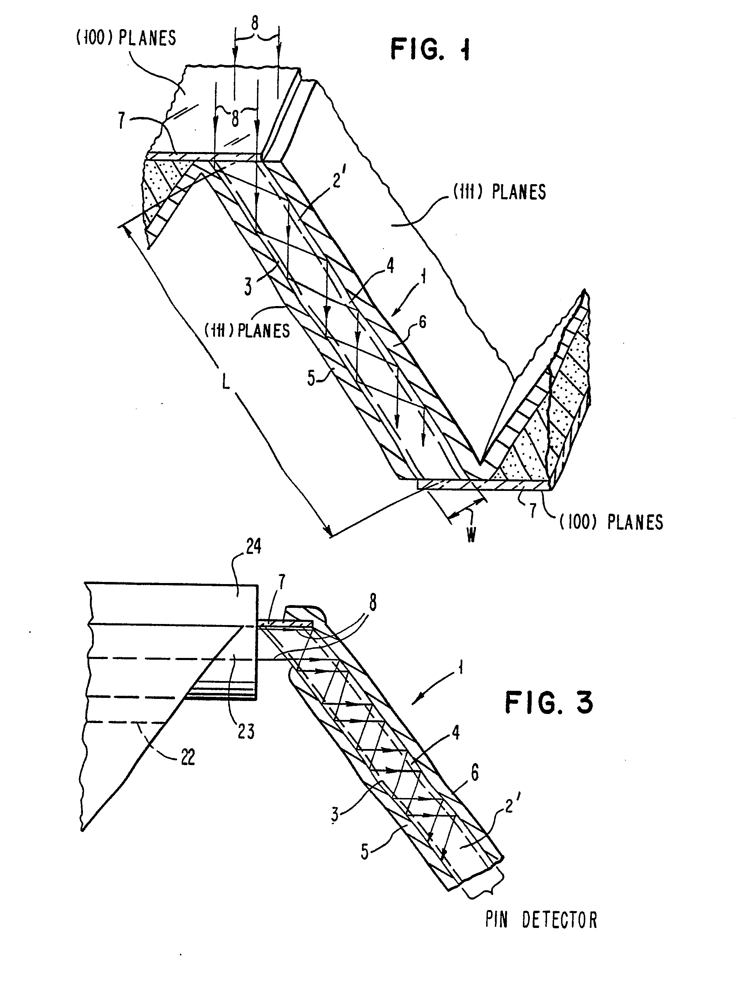

A photodetector 1 (FIG. 1) comprises a web $2^1$ of semiconductor material, preferably high resistivity silicon, having disposed therein regions of p and n-type conductivity 3,4, respectively, which extend from atomically parallel surfaces of the web $2^1$ for a small distance into the web. The remaining central region of web $2^1$ is intrinsic in character. A first metal contact electrode 5 is connected to p-type conductivity region 3 while a second metal contact electrode 6 is connected to n-type conductivity region 4. Metal electrodes 5,6 may be made of aluminum, or any other suitable metal, so that they are reflecting in character to provide internal reflection of incident light received by the photodetector. Finally, a layer 7 of silicon dioxide or other transparent material which is anti-reflecting in character has a portion thereof extending over one end of web $2^1$ so that light rays 8 may be coupled into web $2^1$ in such a way that light rays 8 undergo multiple reflections within web $2^1$ and are totally absorbed therein due to the long path length encountered by the impinging light rays 8. Because of the total absorption of radiant energy in web $2^1$, light rays may also be applied via layer 7 at the bottom of the photodetector 1. In this way, a single device may be time shared to be responsive to the outputs of two separate light sources provided their outputs do not overlap.

Light rays 8 are totally absorbed inasmuch as the length of the light path is very long compared with the reciprocal of absorption coefficient of the semiconductor at the wavelength being detected.  The width $W$ between the contact electrodes 5 and 6 should be as small as possible to provide for high speed detection of the impinging light.  If the width $W$ is very small, optically generated carriers must then travel only a small distance to be collected from their point of generation in web $2^1$. In FIG. 1, web $2^1$ is fully depleted of carriers by making it of undoped or lightly doped silicon.  Alternatively, if the regions 3,4 extend so far into the web that they meet so that there is no central intrinsic region of web $2^1$, the central region is fully depleted of carriers by reverse biasing.

In the photodetector of FIG. 1, carriers that are optically generated are transported by a drift mechanism which is very rapid compared with the much slower diffusion mechanism.  The speed of the detector response is determined ultimately by the transit time of the carrier which can be very fast for a small distance $W$.

The photodetector of FIG. 1 can be used for unguided light as indicated by light rays 8.  However, it should be appreciated that width $W$ is often determined by some dimension of a coupling element used to optically couple light into web $2^1$.  Thus, where an optical fibre is coupled to web $2^1$, width $W$ is often determined by the diameter of the optical fibre.

In addition to high speed response, the photodetector of FIG. 1 has a high collection efficiency of the optically generated carriers within web $2^1$ because regions 3,4 are located within a few microns of where hole-electron pairs are generated.  In addition, the use of an optical anti-reflecting coating for layer 7 assures high efficiency optical transfer into web $2^1$ and metal contacts electrodes 5, 6 which are reflecting in character serve as internal reflectors of light energy propagated along web $2^1$.

The following example is provided to illustrate the rise time of photodetector of FIG. 1. The example shows the drift time of carriers across the width W.

Equation 1:
$$t_{rise} = \frac{W}{Vd}$$

where $V_d = \varepsilon\mu$ is the drift velocity of the carriers. For drift field $\varepsilon = 10^4$ V/cm and mobility $\mu = 10^3$ cm$^2$ v$^{-1}$ s$^{-1}$, $V_d$ approaches the saturation velocity which is $\cong 10^7$ cm s$^{-1}$.

Thus the rise time of this device is about 300 ps.

The small absorption usually obtained in planar detectors can be seen from the following example using an optical signal of 900 nanometers wavelength. Such a wavelength is available from a gallium arsenide injection laser source. For a width W of 3 microns, the amount of light absorbed can be determined from the following equation+

Equation 2:     $P/P_o = \exp(\alpha_{Si} W)$
            where P is optical power at
                distance W
                $P_o$ is optical power entering
                substrate 2
                $\alpha_{Si}$ is the optical absorption
                coefficient.
            where $\alpha_{Si}$ at 900 nm equals 300 cm$^{-1}$.
            If W = 3 micrometers,
            then $P/P_o = \exp(-300 \times 3)$
                    $= 0.914$

Thus, approximately 1% of the impinging light is absorbed. It is, therefore, desirable to make the effective optical length much larger than the electric path W by folding the optical path using reflectors at the detector boundaries to cause reflection internally of web $2^1$. For instance, with approximately 15 internal reflections within the photodetector, nearly all the incident light is absorbed.

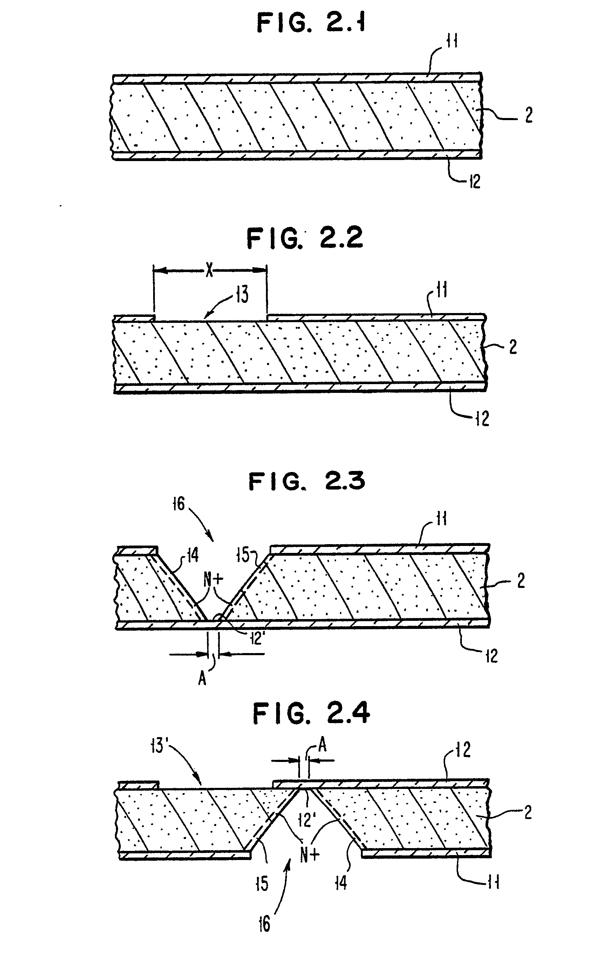

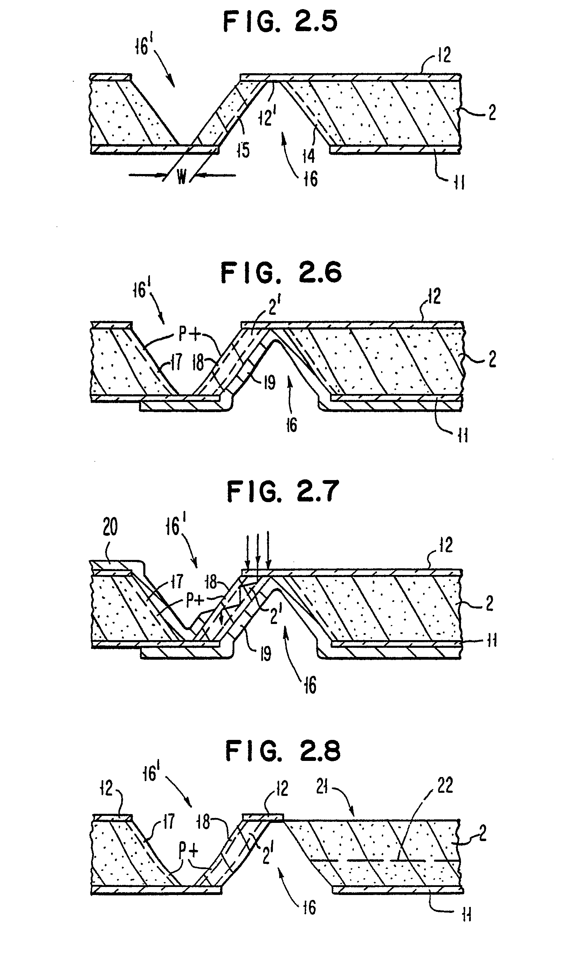

Referring now to FIGS. 2.1-2.7, there are shown various stages in a fabrication process resulting in a structure as shown in FIG. 2.7 which is similar to that shown in FIG. 1.

Referring now to FIG. 2.1, silicon substrate 2 which is intrinsic or lightly doped using a p conductivity type dopant such as boron has insulating layers 11,12 of silicon dioxide or silicon nitride formed on opposite surfaces thereof. The surface of silicon substrate 2 has a (100) crystallographic orientation. Layers 11,12 may be formed by the thermal oxidation of silicon in a well known way or by chemical vapor deposition of silicon dioxide or silicon nitride.

FIG. 2.2 shows substrate 2 after a slot 13 having a width x has been opened in layer 11 using well known photolithographic and etching techniques.

FIG. 2.3 shows substrate 2 after it has been anisotropically etched through the entire thickness of the substrate. Anisotropic etching for a silicon substrate having a (100) crystalline orientation etches into substrate 2 at an angle of 54.7° from the surface of the substrate with the normal to the V-groove surfaces aligned parallel to the [111] crystalline axis of the silicon substrate. Anisotropic etchant and etching processes for silicon are well known in the semiconductor art. In one method, a mixture of 120 milliliters of ethylenediamine, 22 grams of pyrocatechol, and 60 milliliters of water is used to perform the anisotropic V-groove etching. The etchant temperature is maintained at 104°-110°C during the time necessary to etch through silicon substrate 2. While the time of etching varies with the thickness of substrate 2, anisotropic etching should be continued until a portion 12' of layer 12 having a width A is exposed. After etching, substrate 2 is cleaned in hot methyl alcohol and rinsed in deionized water. Then, regions 14,15 are formed by diffusing an n-type dopant into the exposed surfaces of groove 16. Doped regions 14,15 are heavily doped so that the conductivity type becomes $n^+$. The doping of regions 14,15 is carried out in a manner well known to those skilled in the semiconductor fabrication art.

In FIG. 2.4, substrate 2 is shown after it has been inverted and a slot 13' opened in layer 12 in a manner similar to that described in connection with FIG. 2.2. Slot 13' should be displaced from the edge of exposed portion 12' of layer 12 by an amount a little greater than the dimension W shown in FIG. 1. Doing this provides a mask during a subsequent anisotropic etching step which controls the thickness of a web to be formed which, in turn, ultimately controls the speed of a detector device like that shown in FIG. 1.

FIG. 2.5 shows substrate 2 after a second anisotropic etching step has been carried out via slot 13' in the same manner as that described in connection with FIG. 2.3. FIG. 2.5 clearly shows that the width W can be controlled by the displacement of slot 13' from the edge of exposed portion 12' of layer 12. If, as just described, the anisotropic etching step of FIG. 2.5 is carried out after the anisotropic etching step of FIG. 2.3, groove 16 must be masked to prevent over-etching. Alternatively V-groove 16' can be anisotropically etched simultaneously with V-groove 16. In that case, one of the grooves and then the other would have to be masked to prevent diffusion of the same type impurities into both grooves during diffusion. However, if ion implantation of dopants is used as indicated in connection with FIG. 2.6, masking such as is required for diffusion processes can be avoided.

Referring now to FIG. 2.6, the sides of V-groove 16' are doped with boron using well known ion implantation techniques. The concentration of dopant implanted in the surfaces of V-groove 16' is such that the conductivity is $p^+$ in character. It should be appreciated, at this point that the anisotropic etching of V-grooves 16,16' has provided a web 2' with surfaces which are atomically parallel and are very closely spaced. After the ion implantation step, a metal such as aluminum is deposited and defined so that it provides a contact 19 to the $n^+$ conductivity type regions of V-groove 16. Similarly, as shown in FIG. 2.7, metal such as aluminum is deposited and defined in V-groove 16' such that it forms a contact 20 with the $p^+$ conductivity type regions of V-groove 16'. The elements shown in FIG. 2.7 form a photodetector having an intrinsic region disposed between $p^+$ and $n^+$ doped regions to which metal contacts are applied. In addition to forming a photodetector which permits complete absorption of the impinging light, windows are automatically formed in portions of layers 11,12 over the ends of web 2' through which light enters semiconducting web 2'. In addition, the photodetector is disposed at an angle with respect to the impinging light permitting the light to be reflected internally of the semiconductor material so that it is totally absorbed.

FIGS. 2.1-2.7 show a process which provides a detector device which can be used with unguided light. To couple light to the detector of FIG. 1 by means of an optical fibre entails only another anisotropic etching step to provide a groove in which an optical fibre is positioned. If after ion implantation has been carried out and before metallization 19 has been defined as shown in FIG. 2.6, another slot 21 is opened in layer 12 as shown in FIG. 2.8, another V-groove 22 perpendicular to V-groove 16 can be etched in the same manner as described hereinabove to receive an optical fibre.

FIG. 3 shows an end view of a photodetector after V-groove 22 has been etched in substrate 2 and the metallization step of FIG. 2.7 has been completed. An optical fibre 23 held in a sheath or cladding 24 is shown disposed in V-groove 22 which has been etched to a depth which permits light rays 8 from optical fiber 23 to pass into photodetector 1 where they are totally absorbed. Another optical fibre, like fiber 23, may be disposed at the bottom of web 2' in a groove similar to V-groove 22 so that photodetector 1 of FIG. 3 can respond to inputs from two optical fibres. The light inputs from the two fibres should be sufficiently displaced in time to provide discrete electrical outputs.

There has been described herein a PIN photodetector that has a faster transit time than known devices with equivalent optical absorption or, more optical absorption than a device with equivalent speed. The device can be used in conjunction with optical fibres as a detector, for on and off chip communication and infrared and x-ray detection.

## CLAIMS

1. A radiation detector comprising a parallel pair of strips (7) of insulating material joined by a body ($2^1$) of semiconductor material, one surface layer (3) of the body being of one conductivity type and an opposite surface layer (4) of the body being of the opposite conductivity type, characterised by the body being in the form of a parallel-sided web disposed obliquely to the parallel pair of strips, one surface layer of the web being of p-type conductivity and the opposite surface layer of the web being of n-type conductivity.

2. A detector as claimed in any preceding claim, in which the length of the web is much greater than its width.

3. A detector as claimed in claim 1 or claim 2, in which at least one of the strips of insulating material is transparent to radiation.

4. A detector as claimed in any preceding claim, in which the strips are of material which is anti-reflecting in character.

5. A detector as claimed in claim 4, in which the strips are of silicon dioxide.

6. A detector as claimed in any preceding claim, in which the body is of silicon.

7. A detector as claimed in any preceding claim, in which an inner layer of the body is of intrinsic or lightly doped semiconductor material.

8.    A detector as claimed in any preceding claim, in which an individual, radiation reflecting electrode is contiguous with each of the one and the opposite surface layers of the web.

9.    A detector as claimed in any preceding claim including radiation guide means coupled to at least one of the one and the opposite surface layers of the web.

10.   A detector as claimed in claim 9, in which the radiation guide means comprises an optical fibre.

11.   A method of fabricating a radiation detector as claimed in any preceding claim, comprising the step of anistropically etching a semiconductor substrate from opposite sides thereof to provide a web of semiconductor material the opposing surfaces of which are parallel.

12.   A method of fabricating a radiation detector as claimed in Claim 11 wherein the opposite sides of the substrate are anisotropically etched simultaneously.

13.   A method of fabricating a radiation detector as claimed in Claim 11 wherein the opposite sides of the substrate are anisotropically etched one after the other.

14.   A method of fabricating a radiation detector as claimed in any of Claims 11 to 13, wherein the step of anisotropically etching includes the steps of forming a layer of masking material on said opposite sides, exposing a portion of each of said opposite sides and applying an anisotropic etchant to said exposed portions.

15.   A method of fabricating a radiation detector as claimed in any of Claims 11 to 14, further including the step of anisotropically etching a groove in at least one of said opposing surfaces of the web, the groove being suitable to receive an optical fibre therein.

16. A method of fabricating a radiation detector as claimed in Claim 15, further including the step of positioning an optical fibre in said groove, one end of the fibre being in optically coupled relationship with one of said opposing surfaces of the web.

0088216

(100) PLANES

**FIG. 1**

(III) PLANES

7

8

8

2'

(III) PLANES

3

4

1

6

5

L

W

7

(100) PLANES

24

7

8

1

**FIG. 3**

22

23

4

6

3

5

2'

PIN DETECTOR

FIG. 2.1

11

2

12

FIG. 2.2

X

13

11

2

12

FIG. 2.3

16

14

15

11

N+

2

12'

12

A

FIG. 2.4

13'

A

12

2

12'

N+

15

14

11

16

0088216

## FIG. 2.5

## FIG. 2.6

## FIG. 2.7

## FIG. 2.8